**Europäisches Patentamt**

**European Patent Office**

**Office européen des brevets**

(11) Veröffentlichungsnummer: **0 317 842**
**A2**

# EUROPÄISCHE PATENTANMELDUNG

(21) Anmeldenummer: **88118804.9**

(22) Anmeldetag: **11.11.88**

(51) Int. Cl.⁴: **B05D 1/40 , B05C 11/02 , B05C 11/10**

(30) Priorität: **25.11.87 DE 3739873**

(43) Veröffentlichungstag der Anmeldung:
**31.05.89 Patentblatt 89/22**

(84) Benannte Vertragsstaaten:
**AT CH DE ES FR GB IT LI NL SE**

(71) Anmelder: **Hausmann, Kurt**
**Hans-Böckler-Strasse 3-7**
**D-8903 Bobingen(DE)**

(72) Erfinder: **Hausmann, Kurt**
**Hans-Böckler-Strasse 3-7**
**D-8903 Bobingen(DE)**

(74) Vertreter: **Munk, Ludwig, Dipl.-Ing.**
**Patentanwalt Prinzregentenstrasse 1**
**D-8900 Augsburg(DE)**

(54) Verfahren und Vorrichtung zum Beschichten eines bahnförmigen Substrats.

(57) Bei der Beschichtung von bandförmigem Material mit einem mittels einer Auftragwalze (4) aufgetragenen, fließfähigen Beschichtungsmedium lassen sich dadurch eine hohe Genauigkeit und Reproduzierbarkeit sowie eine hohe Bedienungsfreundlichkeit erreichen, daß der Auftragwalze (4) eine Dosierwalze (5) nachgeordnet ist, die eine profilierte Oberfläche aufweist und die Beschichtungsmedium vom Substrat (1) abquetscht, wobei durch die profilierte Oberfläche eine Dosierung des auf dem Substrat verbleibenden Beschichtungsmediums erfolgt.

FIG 1

EP 0 317 842 A2

## Verfahren und Vorrichtung zum Beschichten eines bahnförmigen Substrats

Die Erfindung betrifft gemäß einem ersten Erfindungsgedanken ein Verfahren zum Beschichten eines bahnförmigen Substrats, insbesondere eines zur Herstellung von Offset-Druckplatten verwendeten Metallband, auf mindestens einer Seite mit einem eine über die ganze Fläche gleichmäßig verteilte Beschichtung bildenden, fließfähigen Beschichtungsmedium, wie Photolack oder dergleichen, und geht gemäß einem weiteren Erfindungsgedanken auf eine Vorrichtung zur Durchführung des Verfahrens mit mit wenigstens einer mit Beschichtungsmedium versorgten, vorzugsweise als in eine Wanne mit Beschichtungsmedium eintauchende Tauchwalze ausgebildeten Auftragwalze, an der das bandförmige Substrat anliegt.

Bei einer bisher verwendeten Lösung wird das Substrat in das Beschichtungsmedium eingetaucht und anschließend über eine Abtropfstrecke geführt. Dieses Tauchverfahren eignet sich jedoch nur für Anwendungsfälle, in denen es nicht auf hohe Genauigkeit und Reproduzierbarkeit ankommt. Bei einer anderen bekannten Lösung eingangs erwähnter Art wirkt das bahnförmige Substrat mit einer Auftragwalze zusammen, wobei durch Schlupf- und Spalteinstellung eine Dosierung der auf das Substrat aufbringbaren Menge erreicht werden soll. Hierbei sind jedoch hohe Fertigungsgenauigkeiten, insbesondere eine hohe Rundlaufgenauigkeit der Walzen, sowie eine hohe Schwingungssicherheit und Vibrationsfreiheit erforderlich, sofern es um Genauigkeit und Reproduzierbarkeit geht, da sich Rundlauffehler, Schwingungen und dergleichen, ungünstig auf die erzielbare Genauigkeit auswirkt. Dasselbe gilt für Störgrößen wie Wärmedehnungen, Geschwindigkeitsschwankungen, Bahnzugschwankungen, Viskositätsänderungen infolge von Verschmutzungen und dergleichen, die ebenfalls zu einer Änderung der Auftragsmenge führen können. Hierbei sind daher eine eine ständige Überwachung und Nachregelung erforderlich.

Hiervon ausgehend ist es die Aufgabe der vorliegenden Erfindung, die Beschichtung von bahnförmigem Substrat so zu gestalten, daß mit einfachen und kostengünstigen Mitteln eine hohe Genauigkeit und Reproduzierbarkeit erreicht werden können und eine hohe Bedienungsfreundlichkeit gewährleistet ist.

Diese Aufgabe wird verfahrensmäßig dadurch gelöst, daß das Beschichtungsmedium zunächst im Überschuß aufgetra gen und anschließend bis auf ein Profil abgestreift wird, das ein vorgegebenes Volumen enthält und selbsttätig verläuft. Hierzu wird ausgehend von der eingangs umrissenen Vorrichtung mindestens eine in Laufrichtung des bandförmigen Substrats gegenüber der Auftragwalzenanordnung versetzte, eine profilierte Umfangsfläche aufweisende Dosierwalze vorgesehen, an der das bandförmige Substrat straff anliegt und in deren Bereich eine Auffangwanne für abgequetschtes, abtropfendes Beschichtungsmedium vorgesehen ist.

Die erfindungsgemäße Kombination beschreitet im Gegensatz zu der bekannten Lösung, bei der vor dem Auftrag durch Schlupf- und Spalteinstellung dosiert wird, den Weg, zunächst eine Überschußmenge an Beschichtungsmedium aufzutragen und anschließend hiervon die Teilmenge abzunehmen, die über die für die gewünschte Beschichtung benötigte Teilmenge hinausgeht. Die Dosierung wird dabei in vorteilhafter Weise durch das auf alle Fälle konstant bleibende Fassungsvermögen des Profils der Auftragwalze bewerkstelligt. Eine Spalt- bzw. Schlupfeinstellung ist hierbei nicht erforderlich. Ebenso ist nicht zu befürchten, daß sich Störgrößen ungünstig auf die erzielbare Genauigkeit und Reproduzierbarkeit auswirken. Die erfindungsgemäße Lösung ist daher regelungstechnisch äußerst einfach und leicht beherrschbar, was sich vorteilhaft auf die erzielbare Bedienungsfreundlichkeit auswirkt. Ein weiterer Vorteil der mit Hilfe des fest vorgebbaren Profils der Auftragwalze erzielbaren, von Störgrößen unabhängigen, konstanten Auftragsmenge ist darin zu sehen, daß auch die beim Anfahren des Bands bzw. beim Auslauf des Bands sich ergebenden Verluste minimal sind. Hinzu kommt, daß vergleichsweise große Fertigungstoleranzen zugelassen werden können, so daß sich der erforderliche Bauaufwand in Grenzen hält.

Gemäß einer vorteilhaften Ausgestaltung der übergeordneten Maßnahmen besitzt die Dosierwalze einen Durchmesser, der kleiner als der Durchmesser der Auftragwalze ist. Der große Durchmesser der Auftragwalze gewährleistet einen zuverlässigen Transport einer großen Überschußmenge des Beschichtungsmediums auf das bandförmige Substrat. Der kleine Durchmesser der Dosierwalze erleichtert in vorteilhafter Weise eine exakte Anlage des Substrats an der Dosierwalze.

Eine weitere vorteilhafte Maßnahme kann darin bestehen, daß die Dosierwalze als im Bereich ihrer Enden gelagerte Walze ausgebildet ist. Hierbei ergibt sich eine einfache Ableitung der Stützkräfte über die seitlichen Lager in das Maschinengestell. Eine gewisse Durchbiegung aufgrund der Stützkräfte ist völlig unschädlich, da das Fassungsvermögen des Profils und damit die Auftragsmenge hierdurch nicht beeinträchtigt werden. Es ist daher ohne weiteres eine straffe Anlage des Bands an der Dosierwalze möglich. Dasselbe gilt für eine knickförmige Bandführung, die ein hohe Umschlingung ermöglicht.

Zur Stabilisierung der vorzugsweise einen vergleichsweise kleinen Durchmesser aufweisenden Dosierwalze kann dieser wenigstens eine Stützwalze zugeordnet sein.

Eine weitere vorteilhafte Maßnahme kann darin bestehen, daß die Dosierwalze in die zugeordnete Auffangwanne, die mit Beschichtungsmedium beaufschlagt wird, eintaucht und zumindest bei Stillstand des Substrats angetrieben wird. Mit diesen Maßnahmen wird sichergestellt, daß die Dosierwalze auch bei Stillstand der Bahn infolge von anderweitigen Störungen zuverlässig benetzt wird, so daß einem Antrocknen des Beschichtungsmediums wirksam vorgebeugt wird.

Zur Erleichterung des Bahneinzugs und Gewährleistung eines zuverlässigen Kontakts insbesondere der Dosierwalze mit dem bahnförmigen Substrat können die Dosierwalze, vorzugsweise das gesamte Beschichtungsaggregat, gegenüber der Transportebene des Substrats verstellbar angeordnet sein. Zweckmäßig können die Walzen dabei auf den Seitenwänden der sie unterfassenden Wannen gelagert sein, die zu einer verstellbaren Einheit zusammengebaut sein können.

Eine weitere vorteilhafte Maßnahme kann darin bestehen, daß die der Dosierwalze zugeordnete Auffangwanne und die der benachbarten Auftragwalze zugeordnete Wanne durch einen Überlauf strömungsmäßig miteinander verbunden sind, wobei die Auffangwanne mit Beschichtungsmedium beaufschlagt wird und die nachgeordnete Wanne mit einer rücklaufleitung verbunden ist. Diese Maßnahmen stellen sicher, daß beide Wannen mit Beschichtungsmedium gefüllt werden können, und daß dennoch lediglich eine Zuleitung und eine Ableitung erforderlich sind.

Eine weitere vorteilhafte Maßnahme kann darin bestehen, daß die Auftragwalze entgegen der Laufrichtung des bahnförmigen Substrats antreibbar ist. Hierbei ergibt sich beim Auftrag des Beschichtungsmediums ein gewisser Schereffekt und damit eine gute Verteilung. Zur Bewerkstelligung eines zusätzlichen Streicheffekts kann die Dosierwalze ebenfalls mit Schlupf gegenüber der Bahn, vorzugsweise in Laufrichtung der Bahn, antreibbar sein.

Eine weitere, besonders zu bevorzugende Ausgestaltung der übergeordneten Maßnahmen kann darin bestehen, daß die Profilierung der Dosierwalze in Umfangsrichtung umlaufend ausgebildet ist. Ein derartiges, umlaufendes Profil bildet im Berührungsbereich zwischen Dosierwalze und Bahn vorne und hinten offene Kanäle, so daß sich der im Berührungsbereich entstehende Druck von selbst abbauen kann. Eine besonders einfache und dennoch eine hohe Genauigkeit geäwhrleistende Ausführung kann dabei darin bestehen, daß die Profilierung der Dosierwalze durch eine auf einen Kern aufgewickelte Wicklung eines Drahts gebildet wird. Diese Maßnahmen gewährleisten gleichzeitig auch eine hohe Verschleißfestigkeit sowie eine einfache Reparatur.

Um ein Ausweichen des bahnförmigen Substrats zu verhindern, kann der Dosierwalze wenigstens eine ihr gegenüberliegende Quetschwalze zugeordnet sein.

Weitere vorteilhafte Ausgestaltungen und zweckmäßige Fortbildungen der übergeordneten Maßnahmen ergeben sich aus der nachstehenden Beschreibung eines Ausführungsbeispiels anhand der Zeichnung in Verbindung mit den restlichen Unteransprüchen. In der Zeichnung zeigen:

Figur 1 eine schematische Darstellung einer erfindungsgemäßen Beschichtungsanlage,

Figur 2 ein Bespiel für die Oberflächenprofilierung der Dosierwalze und

Figur 3 einen Schnitt durch eine eine Profilierwalze aufnehmende Auffangwanne.

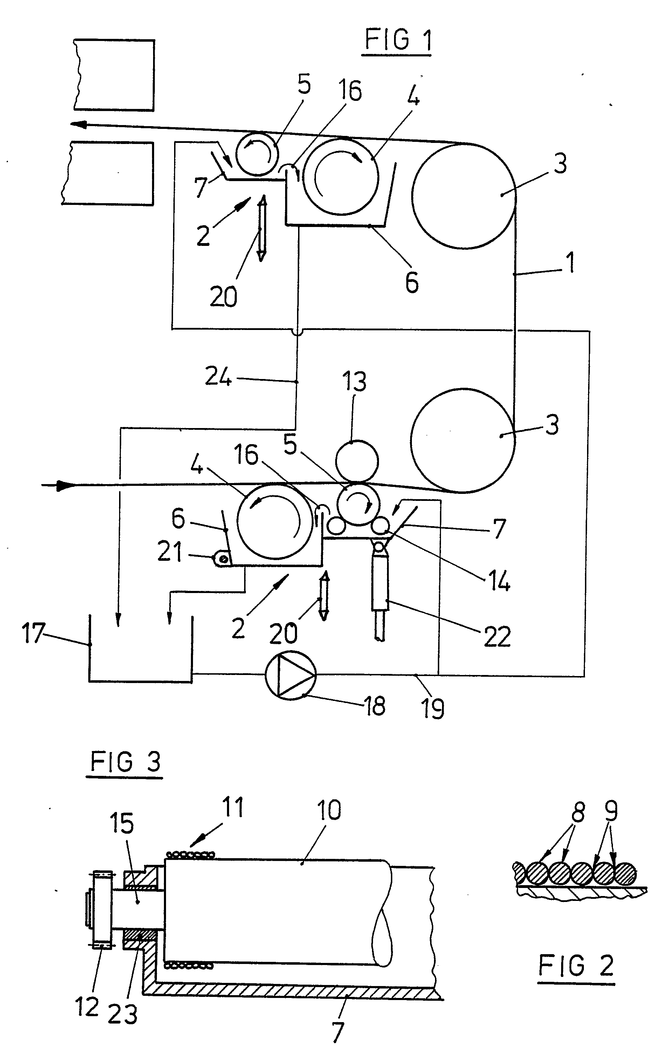

Bei dem der Figur 1 zugrundeliegenden Band 1 soll es sich um ein Metallband in Form eines Aluminiumbands handeln, das zur Herstellung von Offsetdruckplatten mit einem Photolack beschichtet wird. Es könnte sich aber auch um jede andere Art von Band handeln, das mit einer aus fließfähigem Medium mit einem Feststoffgehalt von 3% bis 30% bestehenden Beschichtung versehen wird, beispielsweise mit einer Schutzschicht, einer Versiegelung oder dergleichen.

Im dargestellten Ausführungsbeispiel wird das Band 1 auf beiden Seiten beschichtet. Hierzu sind zwei zum Eingriff mit dem Band 1 kommende Beschichtungsaggregate 2 vorgesehen, die gleichen Aufbau aufweisen können. Der Auftrag des Beschichtungsmediums auf das Band 1 erfolgt im Bereich beider Beschichtungsaggregate 2 von derselben Seite, hier von unten. Das Band 1 wird dementsprechend im Bereich zwischen den beiden Beschichtungsaggreaten 2 um 180° gewendet. Hierzu sind im dargestellten Ausführungsbeispiel zwei übereinander angeordnete Umlenkwalzen 3 vorgesehen, die einen ausreichenden Abstand der deckend übereinander verlaufenden Bandabschnitte ermöglichen.

Die beiden Beschichtungsaggregate 2 umfassen jeweils mindestens zwei mit dem Band 1 zusammenwirkende Walzen in Form einer entgegen der Laufrichtung des Bands 1 angetriebenen, mit Beschichtungsmedium versorgten Auftragwalze 4 und einer dieser nachgeordneten, in Laufrichtung des Bands 1 drehenden Dosierwalze 5. Die Auftragwalze 4 wird im dargestellten Ausführungsbeispiel dadurch mit Beschichtungsmedium versorgt, daß sie als Tauchwalze ausgebildet ist, die in einen in einer sie umfassenden Wanne 6 enthaltenen Vorrat an Beschichtungsmedium eintaucht. Die Auftragwalze 4 nimmt dabei im Bereich ihrer Umfangsfläche eine dicke Schicht des Beschichtungsmediums auf und befördert diese auf das an ihrem Umfang anliegende Band 1. Zur Verbesserung der Haftung kann die Oberfläche der Auftragwalze 4 angerauht sein.

Durch die Auftragwalze 4 wird das Band 1 mit einer grösseren Menge an Beschichtungsmedium versorgt, als zur Bildung der Beschichtung benötigt wird. Die nicht benötigte Teilmenge wird durch die der Dosierwalze 4 nachgeordnete, am Band 1 straff anliegende Dosierwalze 5 abgestreift. Im Bereich des zulaufseitigen Spalts zwischen dem Band 1 und der Dosierwalze 5 bildet sich dementsprechend ein Stau des Beschichtungsmediums, wobei dieses teilweise infolge der Schwerkraftwirkung nach unten abtropft. Zum Auffangen des nach unten abtropfenden Beschichtungsmediums ist daher eine Auffangwanne 7 vorgesehen, die hier die Dosierwalze 5 und die dieser benachbarten Bereiche unterfaßt.

Zur Bewerkstelligung einer exakten Dosierung besitzt die Dosierwalze 5, an der das Band 1 stramm anliegt, eine profilierte Mantelfläche mit durch Stege 8 voneinander getrennten Vertiefungen 9, wie am besten aus Figur 2 erkennbar ist. Diese Profilierung der Oberfläche der Dosierwalze 5 ergibt eine entsprechende negative Profilierung des auf dem Band 1 verbleibenden Beschichtungsmediums. Da die Stege 8 und Vertiefungen 9 des Profils der Dosierwalze 5 einen genau vorgegebenen lichten Querschnitt besitzen, besitzt auch das auf dem Band 1 verbleibende Negativprofil eine genau vorgegebene, geometrische Konfiguration und damit ein genau vorgegebenes Volumen. Dieses ist dabei lediglich von der geometrischen Konfiguration der Profilierung der Dosierwalze abhängig.

Die Profilierung der Dosierwalze 5 enthält im dargestellten Ausführungsbeispiel, wie die Figuren 2 und 3 weiter erkennen lassen, in Umfangsrichtung umlaufende Stege 8 bzw. Vertiefungen 9. Hierzu ist beim dargestellten Ausführungsbeispiel auf einen aus Stahl bestehenden Kern 10 der Dosierwalze 5 eine Drahtwicklung 11 aufgebracht, wobei die aneinander anliegenden Windungen des einen kreisförmigen Querschnitt aufweisenden Drahts die umlaufenden Stege 8 und die vom Berührungsbereich nach radial außen sich erweiternden Rinnen zwischen den aneinander anliegenden Windungen die umlaufenden Vertiefungen 9 bilden. Der Durchmesser des zur Bildung der Wicklung 11 verwendeten Drahts liegt im Bereich zwischen 0,1mm und 1,0mm, vorzugsweise im Bereich zwischen 0,2mm und 0,4mm und soll im dargestellten Ausführungsbeispiel 0,3mm betragen. Die in Umfangsrichtung umlaufenden Stege 8 und Vertiefungen 9 ergeben infolge des vergleichsweise kleinen Querschnitts der Stege 8 und Vertiefungen 9 eine feine Verteilung des Beschichtungsmediums, die mit der im Falle eines manuellen Auftrags mit Hilfe eines Pinsels erzielbaren Verteilung des Auftragsmediums entspricht. Dieser Streicheffekt läßt sich dadurch noch verbessern, daß zwischen der Bahn 1 und der Dosierwalze 5 ein gewisser Schlupf vorhanden ist. Im Falle einer durch Friktion mitgenommenen, frei drehbar gelagerten Dosierwalze 5 könnte dieser Schlupf durch eine gewisse Schwergängigkeit im Bereich der Lagerung erreicht werden. Im dargestellten Ausführungsbeispiel wird die Dosierwalze mit einer von der Geschwindigkeit der Bahn 1 abweichenden Geschwindigkeit angetrieben und ist hierzu, wie aus Figur 3 entnehmbar ist, mit einem Antriebsrad 12 versehen. Die Drehrichtung der Dosierwalze entspricht der Laufrichtung des Bands 1. Der Antrieb der Dosierwalze 5 erfolgt dementsprechend mit gegenüber der Bandgeschwindigkeit größerer oder vorzugsweise etwas kleinerer Umfangsgeschwindigkeit.

Die im dargestellten Ausführungsbeispiel vorgesehene umlaufende Profilierung der Dosierwalze 5 ergibt im Berührungsbereich zwischen Dosierwalze 5 und Band 1 nach vorne und hinten offene, durch die Vertiefungen 9 gebildete Kanäle, die einen schnellen Druckabbau im Bereich der Berührungszone ermöglichen. Es wäre aber auch denkbar, die Dosierwalze 5 mit einer Näpfchenprofilierung, d. h., mit eine geschlossene Umrandung aufweisenden Vertiefungen zu versehen, die ein genau bestimmtes Fassungsvermögen besitzen und aus denen durch Spaltung des Beschichtungsmediums eine genau bestimmbare Menge an Beschichtungsmedium herausgeholt wird. In jedem Falle ist die Feinheit der Profilierung, d. h. der Abstand der Stege 8, so auf die Fließfähigkeit des Beschichtungsmediums abzustimmen, daß das auf das Band 1 aufgebrachte, aus Beschichtungsmedium bestehende Negativprofil selbsttätig verlaufen kann und sich somit eine glatte Beschichtungsoberfläche ergibt.

Zur zuverlässigen Anpressung des Bands 1 an das Oberflächenprofil der Dosierwalze 5 kann dieser eine Quetschwalze 13 zugeordnet sein, wie in Figur 1 im Falle des unteren Beschichtungsaggregats 2 dargestellt ist. Vielfach reicht aber bereits der Zug des Bands 1 aus, um eine satte Anlage an der Dosierwalze 5 zu bewerkstelligen, wie in Figur 1 im Falle des oberen Beschichtungsaggregats 2 dargestellt ist. Hierbei wird gleichzeitig erreicht, daß die frische Beschichtung der schon beschichteten Seite des Bands 1 nicht beschädigt wird. Die satte Anlage des Bands 1 an der Dosierwalze 5 und ggf. der Auftragwalze 4 läßt sich auch dadurch verbessern, daß das Band 1 die Walzen nicht nur tangiert, sondern in Form eines Knicks leicht umschlingt.

Zur weiteren Verbesserung des Kontakts zwischen der Dosierwalze 5 und dem Band 1 ist der Durchmesser der Dosierwalze 5 im Vergleich zum Durchmesser der Auftragwalze 4 klein bemessen. Der Durchmesser der Dosierwalze 5 liegt vorzugsweise im Bereich zwischen 40mm und 200mm, wobei die Auswahl so getroffen werden kann, daß der Durchmesser und damit die Tragfähigkeit der Dosierwalze 5 gerade ausreicht, um die aus der Zugspannung des Bands 1 resultierenden Stützkräfte ohne größere Durchbiegung aufnehmen zu können. Zur zusätzlichen Stabilisierung der einen vergleichsweise kleinen Durchmesser aufweisenden Dosierwalze 5 können dieser, wie in Figur 1 wiederum an hand des unteren Beschichtungsaggregats 2 angedeutet ist, eine oder mehrere Stützwalzen 14 zugeordnet sein.

Die Dosierwalzen 5 sind im dargestellten Ausführungsbeispiel, wie Figur 3 weiter erkennen läßt, mit seitlichen Lagerzapfen 15 in den Seitenwänden der zugeordneten Auffangwanne 7 gelagert. Ebenso können die Auftragwalzen 4 in den Seitenwänden der jeweils zugeordneten Wanne 6 gelagert sein. Jeweils einer der Lagerzapfen trägt das außerhalb der jeweiligen Wanne angeordnete Antriebsrad 12. Im dargestellten Ausführungsbeispiel sind, wie Figur 1 weiter erkennen läßt, die der Auftragwalze 4 jeweils zugeordnete Wanne 6 und die der benachbarten Dosierwalze 5 jeweils zugeordnete Auffangwanne 7 aneinander angesetzt. Im Bereich der gemeinsamen Zwischenwand ist dabei ein durch einen Pfeil 16 angedeuteter Überlauf vorgesehen, so daß der Wanneninhalt von der infolge des kleineren Durchmessers der Dosierwalze 5 höher gelegenen Auffangwanne 7 in die infolge des größeren Durchmessers der Auftragwalze 4 tiefer liegende Wanne 6 ablaufen kann.

Das Beschichtungsmedium wird in einem Behälter 17 bereitgehalten und mittels einer an diesen angeschlossenen Pumpe 18 über eine Versorgungsleitung 19, die mit zu jedem Beschichtungsaggregat 2 führenden Stichleitungen versehen ist, den einzelnen Beschichtungsaggregaten 2 zugeführt. Im dargestellten Ausführungsbeispiel münden die Stichleitungen der Versorgungsleitung 19 jeweils in die der Dosierwalze 5 zugeordnete Auffangwanne 7. Sofern, wie in dargestellten Beispiel, eine Durchlaufversorgung erwünscht ist, kann die tieferliegende, durch den Überlauf 16 aus der Auffangwanne beaufschlagte Wanne 6 an eine zum Behälter 17 führende Rücklaufleitung 24 angeschlossen sein.

Hierdurch wird erreicht, daß die Auffangwannen 7 stets bis zur Höhe des Überlaufs zur benachbarten Wanne 6 mit Beschichtungsmedium gefüllt sind, so daß die jeweils eintauchende, angetriebene Dosierwalze 5 zuverlässig benetzt wird. Es besteht daher keine Gefahr, daß das Beschichtungsmedium an die Dosierwalz 5 antrocknen könnte. Diese Gefahr bestünde vor allem bei Stillstand des Bands 1. Vielfach genügt es daher, die Dosierwalze lediglich bei Stillstand des Bands über das Antriebsrad 12 anzutreiben.

Zum An- bzw. Abstellen der Auftragwalze 4 und Dosierwalze 5 kann jeweils das gesamte Beschichtungsaggregat 2 auf- und abgefahren werden, wie in Figur 1 durch den Doppelpfeil 20 angedeutet ist. Hierzu kann die aus Wanne 6 und Auffangwanne 7 bestehende Doppelwanne, auf der die zugehörige Auftragwalze 4 und Dosierwalze 5 gelagert sind, mittels eines Lagerbocks 21 schwenkbar gelagert und mittels eines Hubaggregats 22 verschwenkbar sein. Zur zusätzlichen Feineinstellung insbesondere der Dosierwalze 5 und ggf. auch der Auftragwalze 4 können die Lagerzapfen 15 umfassende Exzenterringe 23 vorgesehen sein, wie aus Figur 3 entnehmbar ist.

## Ansprüche

1. Verfahren zum Beschichten eines bahnförmigen Substrats, insbesondere eines Metallbands, auf mindestens einer Seite mit einem eine über die zugeordnete Fläche gleichmäßig verteilte Beschichtung bildenden, fließfähigen Beschichtungsmedium, wie Photolack oder dergleichen, **dadurch gekennzeichnet, daß** das Beschichtungsmedium zunächst im Überschuß aufgetragen und anschließend bis auf ein Profil abgestreift wird, das ein vorgegebenes Volumen enthält und selbsttätig verläuft.

2. Vorrichtung zur Durchführung des Verfahrens nach Anspruch 1 mit wenigstens einer mit Beschichtungsmedium versorgten, vorzugsweise als in eine Wanne (6) mit Beschichtungsmedium eintauchende Tauchwalze ausgebildeten Auftragwalze (4), an der das bandförmige Substrat anliegt, **dadurch gekennzeichnet, daß** in Laufrichtung des bandförmigen Substrats zur Auftragwalzenanordnung versetzt mindestens eine eine profilierte Umfangsfläche aufweisende Dosierwalze (5) vorgesehen ist, an der das bandförmige Substrat straff anliegt und in deren Bereich eine Auffangwanne (7) für abgequetschtes, abtropfendes Beschichtungsmedium vorgesehen ist.

3. Vorrichtung nach Anspruch 2, **dadurch gekennzeichnet, daß** der Durchmesser der Dosierwalze (5) kleiner als der Durchmesser der benachbarten Auftragwalze (4) ist, vorzugsweise im Bereich zwischen 40mm und 200mm liegt.

4. Vorrichtung nach einem der vorhergehenden Ansprüche 2 bis 3, **dadurch gekennzeichnet, daß** der Dosierwalze (5), die vorzugsweise im Bereich ihrer Enden gelagert ist, wenigstens eine Stützwalze (14) zugeordnet ist.

5. Vorrichtung nach einem der vorhergehenden Ansprüche 2 bis 4, **dadurch gekennzeichnet, daß** die Dosierwalze (5) in die zugeordnete Auffangwanne (7), die mit Beschichtungsmedium beaufschlagbar ist, eintaucht und zumindest bei Stillstand des Substrats antreibbar ist, wobei vorzugsweise die der Dosierwalze (5) zugeordnete Auffangwanne (7) und die der benachbarten Auftragwalze (4) zugeordnete Wanne (6) durch einen Überlauf (16) strömungsmäßig miteinander verbunden und die Auffangwanne (7) an eine Versorgungsleitung (19) und die Wanne ( ) an eine Rücklaufleitung (24) für Beschichtungsmedium angeschlossen sind.

6. Vorrichtung nach einem der vorhergehenden Ansprüche 2 bis 5, **dadurch gekennzeichnet, daß** zumindest die Dosierwalze (5), vorzugsweise die Dosierwalze (5) und die benachbarte Auftragwalze (4), an das Substrat anstellbar bzw. hiervon abstellbar, vorzugsweise auf der jeweils zugeordneten Wanne (7 bzw. 6) gelagert sind, die verstellbar angeordnet ist, wobei die der Dosierwalze (5) zugeordnete Auffangwanne (7) und die der benachbarten Auftragwalze (4) zugeordnete Wanne (7) vorzugsweise zusammengebaut und gemeinsam verstellbar sind.

7. Vorrichtung nach einem der vorhergehenden Ansprüche 2 bis 6, **dadurch gekennzeichnet, daß** die Auftragwalze (4) entgegen der Laufrichtung des Substrats antreibbar ist und daß die Dosierwalze (5) in Laufrichtung des Substrats antreibbar ist und vorzugsweise mit Schlupf gegenüber dem Substrat läuft.

8. Vorrichtung nach einem der vorhergehenden Ansprüche 2 bis 7, **dadurch gekennzeichnet, daß** die vorzugsweise über die ganze Breite der Dosierwalze (5) konstant gehaltene Profilierung der Umfangsfläche der Dosierwalze (5) in Umfangsrichtung umlaufend ausgebildet ist, vorzugsweise in Umfangsrichtung umlaufende, durch Stege (8) voneinander getrennte Vertiefungen (9) aufweist.

9. Vorrichtung nach Anspruch 8, **dadurch gekennzeichnet, daß** die Profilierung der Dosierwalze (5) durch eine auf einen Kern (10) aufgewickelte Wicklung (11) eines vorzugsweise durch einen Draht mit kreisförmigem Querschnitt und einem Durchmesser zwischen 0, 1mm bis 1,0mm, vorzugsweise zwischen 0,2mm bis 0,4mm, gebildeten Wickelelements gebildet wird.

10. Vorrichtung nach einem der vorhergehenden Ansprüche 2 bis 9, **dadurch gekennzeichnet, daß** der Dosierwalze (5) wenigstens eine ihr gegenüberliegende Quetschwalzw (13) zugeordnet ist.

11. Vorrichtung nach einem der vorhergehenden Ansprüche 2 bis 10, **dadurch gekennzeichnet, daß** zumindest zwei Beschichtungsaggregate (2) vorgesehen sind, zwischen denen eine dem Substrat zugeordnete Wendeeinrichtung, vorzugsweise in Form von Umlenkwalzen (3), vorgesehen ist.

12. Vorrichtung nach einem der vorhergehenden Ansprüche 2 bis 11, **dadurch gekennzeichnet, daß** das Substrat zumindest im Bereich der vorzugsweise vom Substrat übergriffenen Dosierwalze (5) in Form eines Knicks geführt ist.

EP 0 317 842 A2

FIG 1

FIG 3

FIG 2